(19) Europäisches Patentamt

European Patent Office

Office européen des brevets

(11) **EP 1 352 257 B1**

(12) **EUROPÄISCHE PATENTSCHRIFT**

(45) Veröffentlichungstag und Bekanntmachung des Hinweises auf die Patenterteilung:
**26.04.2006 Patentblatt 2006/17**

(21) Anmeldenummer: **01990365.7**

(22) Anmeldetag: **21.12.2001**

(51) Int Cl.:
*G01R 33/00* (2006.01)

(86) Internationale Anmeldenummer:
**PCT/DE2001/004854**

(87) Internationale Veröffentlichungsnummer:
**WO 2002/056045 (18.07.2002 Gazette 2002/29)**

(54) **VORRICHTUNG ZUR SENSIERUNG EINES MAGNETFELDES, MAGNETFELDMESSER UND STROMMESSER**

DEVICE FOR SENSING A MAGNETIC FIELD, A MAGNETIC FIELD METER AND AN AMMETER

DISPOSITIF POUR DETECTER UN CHAMP MAGNETIQUE, DISPOSITIF DE MESURE DE CHAMP MAGNETIQUE ET AMPEREMETRE

(84) Benannte Vertragsstaaten:
**DE FR GB IT**

(30) Priorität: **11.01.2001 DE 10100884**

(43) Veröffentlichungstag der Anmeldung:
**15.10.2003 Patentblatt 2003/42**

(73) Patentinhaber: **ROBERT BOSCH GMBH**
**70442 Stuttgart (DE)**

(72) Erfinder: **HAUENSTEIN, Henning, M.**
**72762 Reutlingen (DE)**

(56) Entgegenhaltungen:
**US-A- 4 999 692**

- "IMPROVED HALL DEVICES FIND NEW USES" ELECTRONICS, VNU BUSINESS PUBLICATIONS, NEW YORK, US, Bd. 58, Nr. 17, 29. April 1985 (1985-04-29), Seiten 59-61, XP002900568 ISSN: 0883-4989
- ROUMENIN C ET AL: "A new anisotropy effect in the amperometric magnetic-field microsensors" SENSORS AND ACTUATORS A, ELSEVIER SEQUOIA S.A., LAUSANNE, CH, Bd. 77, Nr. 3, 2. November 1999 (1999-11-02), Seiten 195-198, XP004244566 ISSN: 0924-4247
- LIN H-Y ET AL: "A novel structure for three-dimensional silicon magnetic transducers to improve the sensitivity symmetry" SENSORS AND ACTUATORS A, ELSEVIER SEQUOIA S.A., LAUSANNE, CH, Bd. 56, Nr. 3, 1. September 1996 (1996-09-01), Seiten 233-237, XP004049698 ISSN: 0924-4247

EP 1 352 257 B1

**Beschreibung**

Stand der Technik

Die Zahl der Einsatzbereiche für Magnetfeldsensoren wächst zunehmend, insbesondere im Automobilbereich. Die Magnetfeldmessung kann unter anderem zur berührungslosen, verlustarmen und potentialfreien Messung von Strömen genutzt werden. Beispiele sind die Bestimmung elektrischer Betriebsparameter von Generatoren und elektrischen Antrieben. Im Allgemeinen müssen Ströme vom Milliampere- bis zum Kiloamperebereich gemessen werden, was einen Meßbereich von fünf bis sechs Größenordnungen erfordert.

Stand der Technik ist es heute, magnetische Felder, beispielsweise von Stromleitern, durch Magnetfeldsensoren, wie beispielsweise Hall-Sensoren, bipolare Magnetotransistoren, magnetoresistive Widerstände, laterale Magneto-FET-Strukturen etc., zu messen. Ein besonders empfindliches Bauelement ist der sogenannte laterale Magnetotransistor, dessen Funktion auf der durch das Magnetfeld erzeugten asymmetrischen Stromverteilung zwischen zwei bipolaren Transistoren beruht.

Für Ströme im Milliampere-Bereich stoßen selbst solche Bauelemente aufgrund der geringen Magnetfelder, typischerweise im $\mu$T-Bereich an die Grenzen ihrer Empfindlichkeit. Daher werden beim Stand der Technik kleine Magnetfelder durch sogenannte Flußkonzentratoren verstärkt, bei denen man durch geeignete Formgebung der jeweiligen Stromleiter oder durch Magnetkreise aus hochpermeablen Materialien erreicht, dass die Magnetfelder am Ort der Magnetfeldsensoren stärker sind.

Dokumente

*A new anisotropy effect in the amperometric magnetic-field microsensors*"; ROUMENIN C; IVANOV A; NIKOLOVA P; SENSORS AND ACTUATORS VOL. 77; NR. 3; PG: 195-198,

*"A novel structure for three-dimensional silicon magnetic transducers to improve the sensifivity symmetry*"; LIN H-Y; LEI T F; CHANG C-Y; JENG J-J; PAN C-L; SENSORS AND ACTUATORS VOL. 56; NR. 3; PG: 233-237,

*Improved Hall devices find new uses";* ELECTRONICS, VNU BUSINESS PUBLICATIONS, NEW YORK, US; VOL. 58; NR. 17; PG: 59-61 und

US 4 999 692 beschreiben ebenfalls Verschiedener Magnetfeldsensoren.

Vorteile der Erfindung

Die erfindungsgemäße Vorrichtung zur Sensierung eines Magnetfeldes, der erfindungsgemäße Magnetfeldmesser und der erfindungsgemäße Strommesser haben demgegenüber den Vorteil, dass auf flußkonzentrierende Hilfsmittel verzichtet werden kann, was Kosten einspart und den benötigten Bauraum reduziert. Dies ist dadurch möglich, dass die Empfindlichkeit der erfindungsgemäßen Vorrichtung gesteigert wird. Hierbei bleibt der lineare Zusammenhang zwischen dem Meßsignal und dem zu messenden Magnetfeld weitgehend erhalten.

Die Vorliegende Erfindung betrifft eine Vorrichtung zur Sensierung eines Magnetfelds nach Anspruch 1, einem Magnetfeldmesser nach Anspruch 8 und einem Strommesser nach Anspruch 9.

Durch die in den Unteransprüchen aufgeführten Maßnahmen sind vorteilhafte Weiterbildungen und Verbesserungen der in den nebengeordneten Ansprüchen angegebenen Vorrichtung, des Magnetfeldmessers und des Strommessers möglich.

Besonders vorteilhaft ist, dass ein viertes Magnetfeldsensormittel und ein fünftes Magnetfeldsensormittel vorgesehen ist, wobei eine Ausgangsgröße des zweiten Magnetfeldsensorsmittels einer Eingangsgröße des vierten Magnetfeldsensormittels entspricht und wobei eine Ausgangsgröße des dritten Magnetfeldsensormittels einer Eingangsgröße des fünftenMagnetfeldsensormittels entspricht. Dadurch lassen sich durch die Variation der Anzahl der erfindungsgemäßen Kaskadenstufen je nach Bedarf verschiedene Empfindlichkeiten durch Hintereinanderschalten von Magnetfeldsensormitteln darstellen. Hierbei ist insbesondere vorteilhaft, dass verschiedene Magnetfeldsensormittel auf einem einzigen Chip realisiert werden.

Weiterhin ist von Vorteil, dass das erste Magnetfeldsensormittel ein erster lateraler Magnetotransistor ist, dass das zweite Magnetfeldsensormittel ein zweiter lateraler Magnetotransistor ist und dass das dritte Magnetfeldsensormittel ein dritter lateraler Magnetotransistor ist. Dadurch ist erfindungsgemäß eine Empfindlichkeitssteigerung von LMT(laterale Magnetotransistoren)-Sensoren durch eine geeignete Hintereinanderschaltung solcher mehrerer LMT-Bauelemente möglich. Indem man den Ausgangsstrom eines LMT-Elements, d.h. erfindungsgemäß beispielsweise einen der beiden Kollektorströme, als Eingangsstrom, d.h. erfindungsgemäß beispielsweise als Emitterstrom, für ein weiteres LMT-Element benutzt, kann die Asymmetriewirkung des Magnetfeldes auf die Stromverteilung im LMT mehrfach genutzt werden. Hierbei ist vorteilhaft, dass ein LMT-Sensor selbst bereits hochempfindlich ist und damit eine gute Ausgangsbasis für die hier beschriebene Optimierung darstellt. Alternativ kann die vorgestellte Empfindlichkeitssteigerung auch auf alle anderen Bauelement angewendet werden, die nach einem ähnlichen Prinzip arbeiten, d.h. bei denen durch ein Magnetfeld eine Veränderung der Werte von zwei Ausgangsgrößen hervorgerufen wird.

Weiterhin ist von Vorteil, dass die erste Ausgangsgröße ein erster Kollektorstrom ist, dass die zweite Ausgangsgröße ein zweiter Kollektorstrom ist, dass die erste Eingangsgröße der Emitterstrom des zweiten lateralen Magnetotransistors ist und dass die zweite Eingangsgröße der Emitterstrom des dritten lateralen Magnetotransistors ist. Dadurch ist vorteilhaft eine Empfindlichkeitssteigerung möglich, wobei der Zusammenhang zwischen Magnetfeld und Meßsignal für kleine Magnetfelder trotzdem linear ist.

Zeichnung

Ein Ausführungsbeispiel der Erfindung ist in der Zeichnung dargestellt und in der nachfolgenden Beschreibung näher erläutert. Es zeigen

Figur 1 ein Magnetfeldsensormittel nach Art eines lateralen Magnetotransistors,
Figur 2 eine schematische Darstellung eines Magnetfeldsensormittels und
Figur 3 eine erfindungsgemäße Anordnung von mehreren Magnetfeldssensormitteln.

Beschreibung des Ausführungsbeispiels

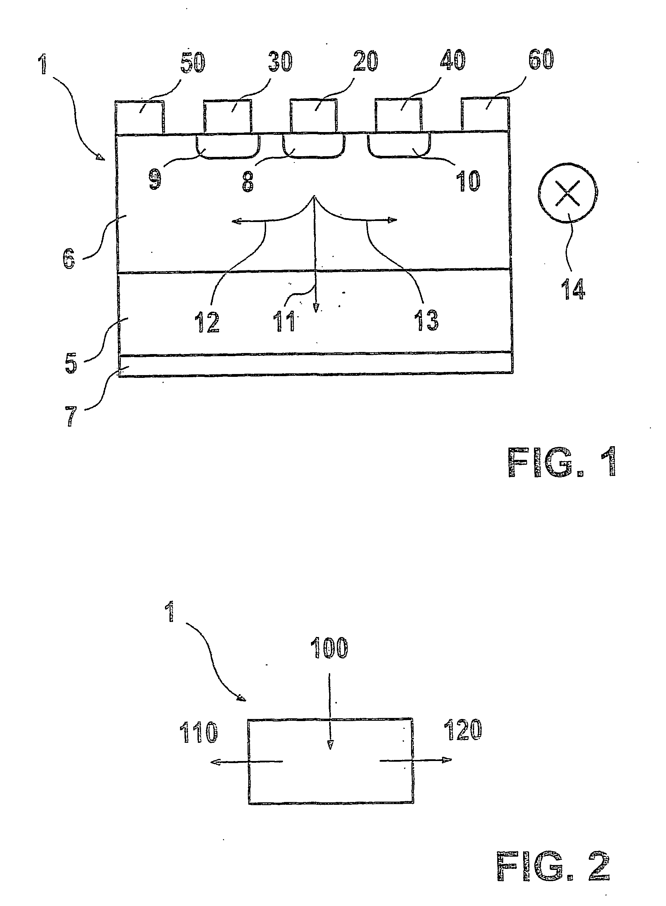

In Figur 1 ist ein Magnetfeldsensormittel 1 anhand eines lateralen Magnetotransistors dargestellt. Das wesentliche Kennzeichen hiervon ist, dass es eine Eingangsgröße und zwei Ausgangsgrößen gibt, wobei bei Abwesenheit eines Magnetfeldes 14 im Bereich des Magnetfeldsensormittels 1 die Werte der Ausgangsgrößen im Wesentlichen gleich groß sind und wobei bei Anwesenheit eines Magnetfeldes 14 eine Asymmetrie zwischen einer ersten Ausgangsgröße 12 und einer zweiten Ausgangsgröße 13 besteht. Für jegliche Magnetfeldsensormittel, die diese grundsätzliche Eigenschaft besitzen, kann die erfindungsgemäße Anordnung von Magnetfeldsensormitteln angewendet werden.

Als Beispiel eines Magnetfeldsensormittels 1 wird in Figur 1 ein lateraler Magnetotransistor 1, abgekürzt auch LMT 1 dargestellt. Der LMT 1 umfasst eine erste Halbleitersubstratschicht 5, welche beispielsweise negativ dotiert ist, und eine zweite Halbleitersubstratschicht 6, welche beispielsweise positiv dotiert ist. Unterhalb der ersten Halbleitersubstratschicht 5, d.h. gegenüber der zweiten Halbleitersubstratschicht 6, ist beispielsweise eine erste Metallisierungsschicht 7 zur Kontaktierung vorgesehen. Die erste Metallisierungsschicht 7 bildet einen Vertikalkollektor des LMT 1. In der zweiten Halbleitersubstratschicht 6 ist ein erster Halbleitersubstratbereich 8 eingebettet, welcher im Beispiel negativ dotiert ist. Weiterhin ist benachbart zu dem ersten Halbleitersubstratbereich 8 ein zweiter Halbleitersubstratbereich 9 und ein dritter Halbleitersubstratbereich 10 in die zweite Halbleitersubstratschicht 6 eingebettet, wobei der erste Halbleitersubstratbereich 8 in der Mitte zwischen dem zweiten Halbleitersubstratbereich 9 und dem dritten Halbleitersubstratbereich 10 liegt. Der zweite und der dritte Halbleitersubstratbereich 9, 10 sind ebenso wie der erste Halbleitersubstratbereich 8 dotiert. Oberhalb des ersten Halbleitersubstratbereichs 8 ist eine erste metallische Kontaktierung 20 angeordnet, die den Emitterkontakt des LMT 1 bildet. Oberhalb des zweiten Halbleitersubstratbereichs 9 ist eine zweite Metallkontaktierung 30 angeordnet, die einen ersten Lateralkollektor des LMT 1 bildet. Oberhalb des dritten Halbleitersubstratbereichs 10 ist eine dritte Metallkontaktierung 40 vorgesehen, die einen zweiten Lateralkollektor des LMT 1 bildet. Neben der zweiten Metallkontaktierung 30 befindet sich auf der der ersten Metallkontaktierung 20 gegenüberliegenden Seite eine vierte Metallkontaktierung 50, die einen ersten Basisanschluß des LMT1 bildet. Neben der dritten Metallkontaktierung 40 befindet sich gegenüber der ersten Metallkontaktierung 20 eine fünfte Metallkontaktierung 60, die einen zweiten Basisanschluß des LMT 1 bildet.

Bei dem LMT 1 fließt ein Strom senkrecht aus dem Emitterbereich 8, d.h. aus dem ersten Halbleitersubstratbereich 8, nach unten. Der erste Strom ist in der Figur 1 mit dem Bezugszeichen 11 versehen. Der erste Strom 11 entspricht dem Eingangsstrom des LMT 1, der über den Emitteranschluß eingespeist wird. Beim Betrieb sind die Kollektoranschlüsse 30, 40 auf das gleiche Potential gelegt und es ergibt sich ein zweiter Strom 12 vom Emitterbereich 8 zum ersten Kollektorbereich 9, d.h. zum ersten Halbleitersubstratbereich 9 und es ergibt sich weiterhin ein dritter Strom 13 vom Emitterbereich 8 zum zweiten Kollektorbereich 10, d.h. zum zweiten Halbleitersubstratbereich 10. Der erste Strom 11 teilt sich erfindungsgemäß entweder vollständig in den zweiten und den dritten Strom 12, 13 auf oder ein Teil des ersten Stromes 11 fließt zum Vertikalkollektor 7. Der erste Fall ist insbesondere dann relevant, wenn kein Vertikalkollektor 7, der auch als Rückseitenkollektor 7 bezeichnet wird, vorgesehen ist. Im zweiten Fall teilt sich der erste Strom 11 nicht vollständig auf den zweiten und dritten Strom 12, 13 auf, sondern es fließt ein Teil des ersten Stromes 11 zum Rückseitenkollektor 7. Bei Abwesenheit des Magnetfeldes 14, d.h. bei dessen Verschwinden, ist der zweite Strom 12 und der dritte Strom 13 im Idealfall, d.h. wenn kein Offset vorliegt, bzw. dieser hinreichend genau abgeglichen ist, gleich groß. Bei Anwesenheit eines Magnetfeldes 14, welches eine Komponente aufweist, die senkrecht in die Bildebene hineinweist, kommt es zu einem Symmetriebruch hinsichtlich des ersten und des zweiten Stroms 12, 13: Einer der Ströme wird größer.

Ohne Magnetfeld 14 fließt im Idealfall durch die beiden Kollektoren 30, 40 der gleiche Strom. Durch ein anliegendes Magnetfeld 14 lateral zur Chipoberfläche werden die Ladungsträger aufgrund der Lorenzkraft je nach Magnetfeldrichtung nach links oder rechts abgelenkt. In der Abbildung ergibt sich durch ein Magnetfeld 14, das senkrecht in die Zeichenebene hineinweist eine stärkere Bestromung des ersten Kollektors 30, mithin ist der zweite Strom 12 größer als der dritte Strom 13und führt daher zu einem relativen Ungleichgewicht der beiden Ströme 12, 13. Die vom Magnetfeld 14 induzierte Stromdifferenz zwischen dem ersten Kollektor 30 und dem zweiten Kollektor 40 ist das Meßsignal. Je größer diese Differenz bei vorgegebener Magnetfeldstärke ist, desto größer ist die Empfindlichkeit der Vorrichtung.

In Figur 2 ist der LMT 1 schematisch dargestellt, wobei lediglich noch eine Eingangsgröße, die dem Eingangsstrom 11 entspricht und jetzt mit dem Bezugszeichen 100 versehen ist, eine erste Ausgangsgröße 110 und eine zweite Ausgangsgröße 120 dargestellt sind.

In Figur 2 ist ein schematisches Ersatzschaltbild des in Figur 1 dargestellten LMT 1 dargestellt. Der ersten Ausgangsgröße 110 entspricht beispielsweise der erste Strom 12, d.h. dem ersten Kollektorstrom des LMT 1. Der zweiten Ausgangsgröße 120 entspricht beispielsweise der zweite Strom 13, d.h. dem zweiten Kollektorstrom des LMT 1. Der Eingangsgröße 100 entspricht beispielsweise der erste Strom 11, d.h. der Emitterstrom des LMT 1. Der für das LMT-Prinzip nicht unbedingt benötigte Substratstrom zum vertikalen Kollektoranschluß 7 ist nicht eingezeichnet. Für die Messung des Magnetfeldes ist es wichtig, dass das Feld eine möglichst große Änderung der Kollektorströme, im Beispiel die Ausgangsgrößen 110, 120 induziert. Je größer diese Änderung relativ zu den ohne Magnetfeld fließenden Ausgangsgrößen 110, 120 ist, desto besser lassen sich auch kleine Magnetfelder 14 messen. Daher kann man die Empfindlichkeit eines LMT-Elements als Verhältnis η = (Betrag der Differenz der Ausgangsgrößen 110, 120 bei angelegtem Magnetfeld 14)/(Betrag der Summe der Ausgangsgrößen 110, 120 bei verschwindendem Magnetfeld 14) definieren. Nimmt man an, dass sich die Eingangsgröße 100, d.h. beispielsweise der Eingangsstrom am Emitter 20, verlustlos in die beiden Ausgangsgrößen 110, 120 aufteilt, dann gilt für ein einzelnes Sensorelement:

$$\text{Erste Ausgangsgröße } 110 = \alpha * \text{Eingangsgröße } 100$$

$$\text{Zweite Ausgangsgröße } 120 = (1-\alpha) * \text{Eingangsgröße } 100,$$

wobei fir den Asymmetriefaktor α im ideal symmetrischen Fall ohne Magnetfeld gilt: α = 0,50.

Hierbei ist α abhängig vom Magnetfeld, welches auch mit dem Buchstaben "B" bezeichnet wird. Ein durch das Magnetfeld veränderter Asymmetriefaktor α wird als α(B) geschrieben. In der Ausgangssituation ohne Magnetfeld ist α = α(0).

In Gegenwart eines dritten, nicht durch Bezugszeichen bezeichneten Substratkollektorstromes zum Vertikalkollektoranschluß 7 reduziert sich der Anteil der Ausgangsgrößen, d.h. der lateralen Ströme 110, 120, entsprechend der Reduzierung des dritten vertikalen Strompfades, d.h. als Eingangsgröße 100 wird nicht der Emitterstrom 11, sondern der Emitterstrom 11 abzüglich des zum Vertikalkollektor 7 fließenden Substratstroms genommen. Für ein einzelnes LMT-Element 1 ergibt sich die Meßempfindlichkeit η als

$$\eta = |2*\alpha(B)-1|$$

für α(0) = 0,50

In Gegenwart eines Magnetfeldes 14 nimmt α linear je nach Feldrichtung mit der parallel zur Oberfläche des LMT 1 verlaufenden Komponente des Magnetfeldes 14 zu bzw. ab.

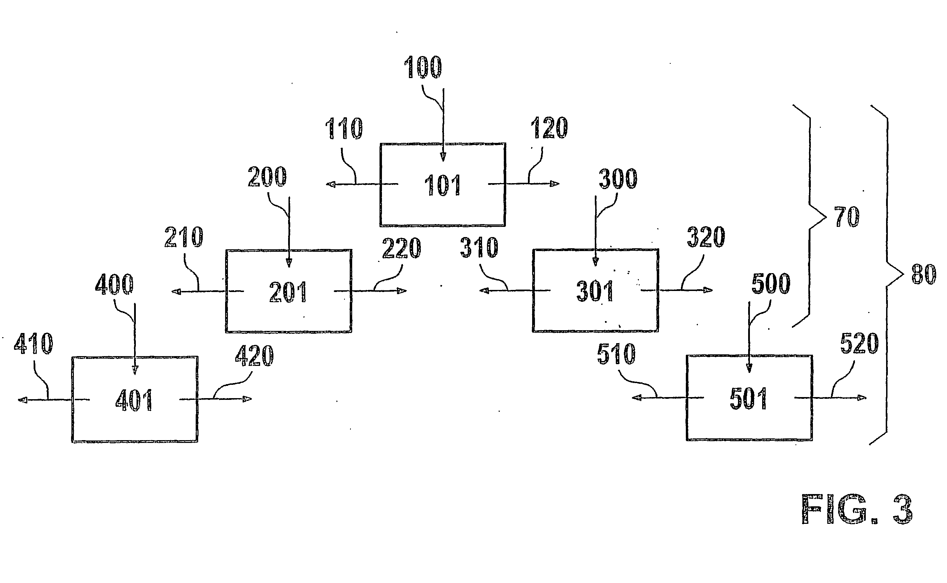

In Figur 3 ist eine erfindungsgemäße Anordnung von Magnetfeldsensormitteln dargestellt. Insgesamt sind ein erstes Magnetfeldsensormittel 101, ein zweites Magnetfeldsensormittel 201, ein drittes Magnetfeldmittel 301, ein viertes Magnetfeldsensormittel 401 und ein fünftes Magnetfeldsensormittel 501 dargestellt. Die Eingangsgröße des ersten Magnetfeldsensormittels 101 ist mit dem Bezugszeichen 100 versehen. Als Ausgangsgrößen weist das erste Magnetfeldsensormittel 101 die erste Ausgangsgröße 110 und die zweite Ausgangsgröße 120 auf. Das zweite Magnetfeldsensormittel 201 weist die mit dem Bezugzeichen 200 versehene Eingangsgröße und als Ausgangsgrößen die erste Ausgangsgröße 210 und die zweite Ausgangsgröße 220 des zweiten Magnetfeldsensormittels 201 auf. Entsprechend weist das dritte Magnetfeldsensormittel 301 eine Eingangsgröße auf, die mit dem Bezugzeichen 300 versehen ist. Als Ausgangsgröße weist das dritte Magnetfeldsensormittel 301 eine erste Ausgangsgröße 310 und eine zweite Ausgangsgröße 320 auf. Das vierte Magnetfeldsensormittel weist eine mit dem Bezugzeichen 400 versehene Eingangsgröße und eine erste, mit dem Bezugzeichen 410 versehene Ausgangsgröße und eine zweite, mit dem Bezugzeichen 420 versehene Ausgangsgröße auf. Das fünfte Magnetfeldsensormittel 501 weist eine mit dem Bezugzeichen 500 versehene Eingangsgröße und eine mit dem Bezugzeichen 510 versehene erste Ausgangsgröße und eine mit dem Bezugzeichen 520 versehene zweite Ausgangsgröße auf. Erfindungsgemäß wird die erste Ausgangsgröße 110 des ersten Magnetfeldsensormittels 101 als Eingangsgröße 200 des zweiten Magnetfeldsensormittels 201 verwendet und es wird die zweite Ausgangsgröße 120 des ersten Magnetfeldsensormittels 101 als Eingangsgröße 300 des dritten Magnetfeldsensormittels 301 verwendet. Wenn das erste, zweite und dritte Magnetfeldsensormittel 201, 301 in Abhängigkeit eines anliegenden Magnetfeldes 14 ein im Wesentlichen gleiches relatives Ungleichgewicht ihrer Ausgangsgrößen 110 und 120 bzw. 210 und 220 bzw. 310 und 320 hervorrufen, dann ist das relative Ungleichgewicht zwischen der ersten Ausgangsgröße 210 des zweiten Magnetfeldsensormittels und der zweiten Ausgangsgröße 320 des dritten Magnetfeldsensormittels größer als das Ungleichgewicht zwischen der ersten Ausgangsgröße 110 des ersten Magnetfeldsensormittels 101 und der zweiten Ausgangsgröße 120 des ersten Magnetfeldmittels 101. Daher ist bei gleichem angelegten Magnetfeld 14 die Sensibilität der Anorndung bestehend aus dem ersten Magnetfeldsensormittel 101 zusammen mit dem zweiten Magnetfeldsensormittel 201 und dem dritten Magnetfeldsensormittel 301 größer als die Empfindlichkeit des ersten Magnetfeldsensormittels allein. Es ergibt sich also durch Hinzufügen weiterer Magnetfeldsensormittel 201, 301, 401, 501 ausgehend von dem ersten Magnetfeldsensormittel 101 die erfindungsgemäße Möglichkeit der Kaskadierung von Magnetfeldsensormitteln. Bei einer solchen Kaskadierung stellt das erste Magnetfeldsensormittel 101 allein sozusagen die erste Stufe der Kaskade dar, das zweite Magnetfeldsensormittel 201 und das dritte Magnetfeldsensormittel 301 stellen die zweite Stufe der Kaskade dar und zusammen bilden das erste Magnetfeldmittel 101, das zweite Magnetfeldmittel 201 und das dritte Magnetfeldmittel 301 eine zweistufige Kaskade 70. Entsprechend stellen alle fünf Magnetfeldsensormittel 101, 201, 301, 401, 501 eine dreistufige Kaskade 80 von Magnetfeldsensormitteln dar. Erfindungsgemäß kann eine beliebige Anzahl von Kaskadenstufen vorgesehen sein. Der Einfachheit halber sind lediglich beispielhaft die ersten drei Kaskadenstufen beschrieben.

Durch die Anzahl der Kaskadenstufen lassen sich je nach Bedarf verschiedene Empfindlichkeiten der erfindungsgemäßen Vorrichtung darstellen. Das Hintereinanderschalten von lateralen Magnetotransistoren 101, 201, 301, 401, 501 kann monolithisch, d.h. auf einem einzigen Chip realisiert werden. Ein LMT-Kaskadenchip kann als Beispiel für eine Magnetfeldsensormittel-Kaskade einen sehr großen Meßbereich abdecken, für den sonst gemäß dem Stand der Technik eine Kombination verschiedener Sensorelemente eingesetzt werden müsste. Bei einer solchen Vorrichtung mit verschiedenen Sensorelementen, die verschiedene Empfindlichkeitsbereiche abdecken, müsste durch Ansteuerung, beispielsweise über einen Auswerte-IC, jeder dieser einzelnen Sensoren an verschiedene Meßbereiche angepasst werden. Dies würde beispielsweise durch unterschiedliche Verstärkung des auszuwertenden Signals erfolgen. Dadurch würde jedoch das Signal-/Rauschverhältnis nicht verbessert. Erfindungsgemäß liegt ein großer Vorteil der erfindungsgemäß vorgeschlagenen Kaskadierung von Magnetfeldsensormitteln darin, dass bei jeder Meßsignalstärke der jeweils geeignete Empfindlichkeitsbereich des Sensors angesprochen und ausgewertet werden kann.

Erfindungsgemäß dient eine Kaskade von mehreren Magnetfeldsensormitteln bzw. von mehreren LMT-Bauelementen zur Erhöhung der Meßempfindlichkeit einer erfindungsgemäßen Vorrichtung. Die Wirkung des Magnetfeldes 14 wird dadurch verstärkt, dass der vom Magnetfeld 14 geänderte Ausgangsstrom eines LMT-Elements jeweils als Eingangsstrom für das nächste LMT-Element benutzt wird und damit erneut der Magnetfeldwirkung unterliegt. Bei einer n-fachen Kaskade von Magnetfeldsensormitteln berechnet sich die Meßempfindlichkeit $\eta$ aus der Stromdifferenz der beiden letzten Kaskadenelemente der Magnetfeldsensormittel der Kaskade wie folgt:

$$\eta_n = \left| \alpha(B)^n - (1-\alpha(B))^n \right| / \left| \alpha(0)^n + (1-\alpha(0))^n \right|$$

Die durch die Kaskade gewonnene Empfindlichkeitssteigerung lässt sich am besten als das Verhältnis der Empfindlichkeiten zwischen n-facher Kaskade ($\eta_n$) und der Empfindlichkeit eines Einzelelementes ($\eta_1$) darstellen:

$$\eta_n : \eta_1 = \left| \alpha(B_z)^n - \left(1-\alpha(B_z)\right)^n \right| / \left\{ \left[ \alpha(0)^n + \left(1-\alpha(0)\right)^n \right] \cdot \left| 2\alpha(B_z) - 1 \right| \right.$$

Falls im Idealfall $\alpha(0)$ als 0,50 angesetzt wird, ergibt sich:

$$\eta_n \, : \, \eta_1 \, = \, 2^{n-1} \, * \, | \, \alpha(B)^n \, - \, (1-\alpha(B))^n \, | \, / \, | \, 2\alpha(B)-1 \, |$$

Für kleine Magnetfelder, d.h. $\alpha$ ungefähr gleich 0,50 steigt die Empfindlichkeit linear mit der Anzahl der Kaskadenstufen. Je mehr Magnetfeldsensormittel man hintereinanderschaltet, bzw. je größer das Magnetfeld 14 ist, desto schneller steigt die Empfindlichkeit $\eta_n$ an. Als Nachteil der Kaskadenschaltung erscheint der Verlust des linearen Zusammenhangs zwischen Meßsignal und Magnetfeld für eine mehr als zweistufige Kaskade. Die Nichtlinearität kann aber zum einen bei der Auswertung des Meßsignals berücksichtigt werden, zum anderen tritt die Nichtlinearität erst dann stark in den Vordergrund wenn $\alpha$ stark von 0,50 abweicht, d.h. für hohe Magnetfelder. Erfindungsgemäß ist es jedoch vor allem die Aufgabe der Erfindung, die Steigerung der Meßempfindlichkeit für kleine Felder zu erreichen, so dass die Kaskadenschaltung insbesondere im Bereich von $\alpha$ ungefähr gleich 0,50 Anwendung findet. In diesem Bereich verhält sich die erfindungsgemäße Kaskadenschaltung von Magnetfeldsensormitteln linear, denn es ergibt sich für $\alpha$ = 0,50, dass $\eta_n = n * \eta_1$, wobei die Empfindlichkeit linear mit der Anzahl n der Kaskadenstufen wächst.

Die erfindungsgemäße Kaskadenschaltung kann sowohl mit einzelnen LMT-Elementen als auch auf einem Chip durch entsprechende Verknüpfung einzelner LMT-Zellen realisiert werden. Die Ansteuerung kann z.B. durch einen ASIC erfolgen. Es besteht auch die Möglichkeit, das Meßsignal auf verschiedenen Kaskadenstufen abzugreifen, so dass je nach Empfindlichkeitsanforderung die auszuwertende Kaskadentiefe gewählt werden kann. Ferner können die LMT-Arbeitspunkte verschiedener Kaskadenstufen, beispielsweise durch die Wahl des jeweiligen Basisstromes, unabhängig voneinander eingestellt werden, wodurch unter Umständen Offset- oder Temperatureffekte kompensiert werden können. Durch die Möglichkeit, prinzipiell jeden Arbeitspunkt der verschalteten Elemente separat einzustellen, kann die erfindungsgemäße Vorrichtung äußerst flexibel mit verschiedenen Ansteuerungs- bzw. Auswertekonzepten kombiniert werden.

Für eine Hintereinanderschaltung ist nicht nur denkbar, den Kollektorstrom als Ausgangsgröße und den Emitterstrom als Eingangsgröße zu verwenden, sondern es ist auch denkbar, zwei Emitter als Ausgänge und einen Kollektor als Eingang des Folgeelements zu nutzen. Die dritte Möglichkeit, den Ausgangsstrom als Basiseingang für das Folgeelement zu verwenden, verspricht sogar eine höhere Empfindlichkeitssteigerung.

Typischerweise haben LMT-Elemente eine Kantenlänge von derzeit etwa 50 bis 100 $\mu$m auf einem Chip. Daher ist die Kaskadierung solcher Elemente leicht erreichbar, indem die LMT-Elemente blockweise nebeneinander oder in einer anderen Ausrichtung auf einem Chip angeordnet werden. Hierbei wird unterstellt, dass das zu messende Magnetfeld 14 an den Orten der verschiedenen auf dem Chip befindlichen LMT-Elemente etwa gleich ist, d.h. das Magnetfeld 14 ist über den Chipbereich, der zur Messung dient, homogen. Dies ist bei den genannten Abmessungen der Sensorelemente eine durchaus plausible Annahme.

## Patentansprüche

1. Vorrichtung zur Sensierung eines Magnetfelds (14) mit einem ersten Magnetfeldsensormittel (1, 101), **dadurch gekennzeichnet, dass** wenigstens ein zweites Magnetfeldsensormittel (201) und ein drittes Magnetfeldsensormittel (301) vorgesehen ist, wobei eine erste Ausgangsgröße (110) des ersten Magnetfeldsensormittels (101) als eine erste Eingangsgröße (200) vorgesehen ist, wobei eine zweite Ausgangsgröße (120) des ersten Magnetfeldsensormittel (101) als eine zweite Eingangsgröße (300) vorgesehen ist, wobei die erste Eingangsgröße (200) als Eingangsgröße für das zweite Magnetfeldsensormittel (201) vorgesehen ist und wobei die zweite Eingangsgröße (300) als Eingangsgröße für das dritte Magnetfeldsensormittel (301) vorgesehen ist.

2. Vorrichtung nach Anspruch 1, **dadurch gekennzeichnet, dass** ein viertes Magnetfeldsensormittel (401) und ein fünftes Magnetfeldsensormittel (501) vorgesehen ist, wobei eine Ausgangsgröße (210) des zweiten Magnetfeldsensormittels (201) einer Eingangsgröße des vierten Magnetfeldsensormittels (401) entspricht und wobei eine Ausgangsgröße (320) des dritten Magnetfeldsensormittels (301) einer Eingangsgröße des fünften Magnetfeldsensormittels (501) entspricht.

3. Vorrichtung nach Anspruch 1 oder 2, **dadurch gekennzeichnet, dass** das erste Magnetfeldsensormittel (101) ein erster lateraler Magnetotransistor (101) ist, dass das zweite Magnetfeldsensormittel (201) ein zweiter lateraler Magnetotransistor (201) ist und dass das dritte Magnetfeldsensormittel (301) ein dritter lateraler Magnetotransistor (301) ist.

**4.** Vorrichtung nach Anspruch 3, **dadurch gekennzeichnet, dass** die erste Ausgangsgröße (110) ein erster Kollektorstrom ist, dass die zweite Ausgangsgröße (120) ein zweiter Kollektorstrom ist, dass die erste Eingangsgröße (200) der Emitterstrom des zweiten lateralen Magnetotransistors (201) ist und dass die zweite Eingangsgröße (300) der Emitterstrom des dritten lateralen Magnetotransistors (301) ist.

**5.** Vorrichtung nach Anspruch 3, **dadurch gekennzeichnet, dass** die erste Ausgangsgröße (110) ein erster Emitterstrom oder eine erste Emitterspannung ist, dass die zweite Ausgangsgröße (120) ein zweiter Emitterstrom oder eine zweite Emitterspannung ist, dass die erste Eingangsgröße (200) der Kollektorstrom oder die Kollektorspannung des zweiten lateralen Magnetotransistors (201) ist und dass die zweite Eingangsgröße (300) der Kollektorstrom oder die Kollektorspannung des dritten lateralen Magnetotransistors (301) ist.

**6.** Vorrichtung nach einem der vorhergehenden Ansprüche, **dadurch gekennzeichnet, dass** die Magnetfeldsensormittel (101, 201, 301, 401, 501) monolithisch integriert vorgesehen sind.

**7.** Vorrichtung nach einem der vorhergehenden Ansprüche, **dadurch gekennzeichnet, dass** eine Auswerteschaltung vorgesehen ist, wobei die Auswerteschaltung in Abhängigkeit des Magnetfeldes (14) die Ausgangsgrößen (110, 120) des ersten Magnetfeldsensormittels (101) oder die erste Ausgangsgröße (210) des zweiten Magnetfeldsensormittels (201) und die zweite Ausgangsgröße (320) des dritten Magnetfeldsensormittels (301) auswertet.

**8.** Magnetfeldmesser mit einer Vorrichtung nach einem der vorhergehenden Ansprüche.

**9.** Strommesser mit einer Vorrichtung nach einem der vorhergehenden Ansprüche.

**Revendications**

**1.** Dispositif pour détecter un champ magnétique (14) avec un premier moyen de détection de champ magnétique (1, 101),
**caractérisé par**
au moins un deuxième moyen de détection de champ magnétique (201) et un troisième moyen de détection de champ magnétique 301), une première grandeur de sortie (110) du premier moyen de détection de champ magnétique (101) prévue comme première grandeur d'entrée (200), une deuxième grandeur de sortie (120) du premier moyen de détection de champ magnétique (101) prévue comme deuxième grandeur d'entrée (300), la première grandeur d'entrée (200) étant prévue comme grandeur d'entrée pour le deuxième moyen de détection de champ magnétique (201) et la deuxième grandeur d'entrée (300) étant prévue comme grandeur d'entrée pour le troisième moyen de détection de champ magnétique (301).

**2.** Dispositif selon la revendication 1,
**caractérisé par**
un quatrième moyen de détection de champ magnétique (401) et un cinquième moyen de détection de champ magnétique (501), une grandeur de sortie (210) du deuxième moyen de détection de champ magnétique (201) est une grandeur d'entrée du quatrième moyen de détection de champ magnétique (401) et une grandeur de sortie (320) du troisième moyen de détection de champ magnétique (301) est une grandeur d'entrée du cinquième moyen de détection de champ magnétique (501).

**3.** Dispositif selon la revendication 1 ou 2,
**caractérisé en ce que**
le premier moyen de détection de champ magnétique (101) est un premier magnétotransistor latéral (101), le deuxième moyen de détection de champ magnétique (201) est un deuxième magnétotransistor latéral (201) et le troisième moyen de détection de champ magnétique (301) est un troisième magnétotransistor latéral (301).

**4.** Dispositif selon la revendication 3,
**caractérisé en ce que**
la première grandeur de sortie (110) est un premier courant collecteur, la deuxième grandeur de sortie (120) est un deuxième courant collecteur, la première grandeur d'entrée (200) est le courant émetteur du deuxième magnétotransistor latéral (201) et la deuxième grandeur d'entrée (300) est le courant émetteur du troisième magnétotransistor latéral (301).

**5.** Dispositif selon la revendication 3,
**caractérisé en ce que**
la première grandeur de sortie (110) est un premier courant émetteur ou une première tension émettrice, la deuxième grandeur de sortie (120) est un deuxième courant émetteur ou une deuxième tension émettrice, la première grandeur d'entrée (200) est le courant collecteur ou la tension collectrice du deuxième magnétotransistor latéral (201) et la deuxième grandeur d'entrée (300) est le courant collecteur ou la tension collectrice du troisième magnétotransistor latéral (301).

**6.** Dispositif selon l'une des revendications précédentes,
**caractérisé en ce que**
les moyens de détection de champ magnétique (101, 201, 301, 401, 501) sont prévus intégrés de façon monolithique.

**7.** Dispositif selon l'une des revendications précédentes,
**caractérisé en ce qu'**
un circuit d'exploitation traite en fonction du champ magnétique (14) les grandeurs de sortie (110, 120) du premier moyen de détection de champ magnétique (101), ou la première grandeur de sortie (210) du deuxième moyen de détection de champ magnétique (201) et la deuxième grandeur de sortie (320) du troisième moyen de détection de champ magnétique (301).

**8.** Dispositif de mesure de champ magnétique avec un dispositif selon l'une des revendications précédentes.

**9.** Ampèremètre avec un dispositif selon l'une des revendications précédentes.

**Claims**

**1.** Apparatus for sensing a magnetic field (14) using a first magnetic-field sensor means (1, 101), **characterized in that** at least one second magnetic-field sensor means (201) and one third magnetic-field sensor means (301) are provided, with a first output variable (110) of the first magnetic-field sensor means (101) being provided as a first input variable (200), with a second output variable (120) of the first magnetic-field sensor means (101) being provided as a second input variable (300), with the first input variable (200) being provided as an input variable for the second magnetic-field sensor means (201), and with the second input variable (300) being provided as an input variable for the third magnetic-field sensor means (301).

**2.** Apparatus according to Claim 1, **characterized in that** a fourth magnetic-field sensor means (401) and a fifth magnetic-field sensor means (501) are provided, with an output variable (210) of the second magnetic-field sensor means (201) corresponding to an input variable of the fourth magnetic-field sensor means (401), and with an output variable (320) of the third magnetic-field sensor means (301) corresponding to an input variable of the fifth magnetic-field sensor means (501).

**3.** Apparatus according to Claim 1 or 2, **characterized in that** the first magnetic-field sensor means (101) is a first lateral magnetotransistor (101), **in that** the second magnetic-field sensor means (201) is a second lateral magnetotransistor (201), and **in that** the third magnetic-field sensor means (301) is a third lateral magnetotransistor (301).

**4.** Apparatus according to Claim 3, **characterized in that** the first output variable (110) is a first collector current, **in that** the second output variable (120) is a second collector current, **in that** the first input variable (200) is the emitter current of the second lateral magnetotransistor (201), and **in that** the second input variable (300) is the emitter current of the third lateral magnetotransistor (301).

**5.** Apparatus according to Claim 3, **characterized in that** the first output variable (110) is a first emitter current or a first emitter voltage, **in that** the second output variable (120) is a second emitter current or a second emitter voltage, **in that** the first input variable (200) is the collector current or the collector voltage of the second lateral magnetotransistor (201), and **in that** the second input variable (300) is the collector current or the collector voltage of the third lateral magnetotransistor (301).

**6.** Apparatus according to one of the preceding claims, **characterized in that** the magnetic-field sensor means (101, 201, 301, 401, 501) are provided in monolithically integrated fashion.

7. Apparatus according to one of the preceding claims, **characterized in that** an evaluation circuit is provided, with the evaluation circuit evaluating the output variables (110, 120) of the first magnetic-field sensor means (101) or the first output variable (210) of the second magnetic-field sensor means (201) and the second output variable (320) of the third magnetic-field sensor means (301) as a function of the magnetic field (14).

8. Magnetic-field meter having an apparatus according to one of the preceding claims.

9. Ammeter having an apparatus according to one of the preceding claims.

1

50 30 20 40 60

9 8 10

6

12 11 13

5

7

14

**FIG. 1**

1

100

110 120

**FIG. 2**

FIG. 3